# EUROPEAN PATENT APPLICATION

(11) **EP 4 167 305 A1**
(43) Date of publication of application: **19.04.2023**
(21) Application number: 21202153.9
(22) Date of filing: 12.10.2021
(51) Int. Cl.: H01L 45/00, H01L 27/22, H01L 27/24

(54) **BAND STRUCTURE ENGINEERED LAYER STACK FOR TWO-TERMINAL SELECTOR AND MEMORY CELL COMPRISING THE SAME**

(71) Applicant: IMEC VZW, 3001 Leuven (BE)
(72) Inventor: GOUX, Ludovic, 4280 Hannut (BE); FANTINI, Andrea, 3001 Heverlee (BE)
(74) Representative: AWA Sweden AB

(57) **Abstract**

The disclosed two-terminal selector device (30), particularly for MRAM or ReRAM cells, comprises a layer stack (20) including a first layer (21) of a semiconductor with a first band-gap in contact with a first electrode (11), a third layer (23) of a semiconductor with a third band-gap in contact with a second electrode (13), and a second layer (22) of a threshold switching material with a second band-gap larger than the first and third band-gaps arranged between the first layer and the third layer. Preferably, the first and third layers are of amorphous Si or Ge, and the second layer is an ovonic threshold switching material of Ge selenide or sulfide type.

## Description

### Technical field

The present inventive concept relates to a layer stack. In particular, it relates to a layer stack for use in a two-terminal selector device.

### Background

In the prior art, Storage Class Memory (SCM) technologies require both high storage density and fast access. In this memory class, the cross-point array concept has been most attractive since the memory element is accessed by a two-terminal selector device at the cross-point of word-lines (WL) and bit-lines (BL), thus allowing a high 2D density.

Some prior art memories in this class combines a phase-change memory (PCM) cell with an Ovonic-Threshold-Switch (OTS) selector to achieve a very large Non-Linearity (NL) of J-V characteristics allowed by a threshold mechanism of an OTS material of the OTS selector. NL is typically measured as the ratio between the ON current at a selected bias voltage Vbias and the OFF current at half Vbias.

However, a drawback of OTS materials is that the current threshold results in a voltage snapback on the OTS selector around 1 V, implying that this voltage redistributes to the memory element. PCM technologies may absorb this voltage snapback without degradation, however other technologies like Magnetic RAM (MRAM) concepts may not to be compatible due to their lower breakdown voltage.

Therefore, the development of dense MRAM arrays for SCM favors the combination of MRAM cells with non-threshold selector concepts such as Metal/Insulator/Metal (MIM) tunneling selector concepts. By using such MIM tunneling selector concepts the MRAM cell is not affected by any voltage snapback, however the NL is largely reduced and therefore requires larger voltages around 3 V to achieve the drive current densities (J) required for read and write operations.

One consequence of a low NL is that the array size is limited by the cumulated leakage paths in non-selected lines. In addition, MIM tunneling selector concepts are also limited in terms of drive current density in ON state (Jon), making it in practice difficult to overcome a limit of Jon=1 MA/cm², which is typically the minimum current density needed to switch a resistive memory element of an MRAM cell.

Hence, today there is no two-terminal selector technology that satisfies the requirements for dense MRAM arrays.

### Summary

An objective of the present inventive concept is to provide a layer stack for a two-terminal selector that enables a dense MRAM array. The layer stack uses band engineering (sometimes called "VARIOT") to achieve an increased NL and Jon with a mitigated voltage snapback.

According to a first aspect of the present inventive concept there is provided a layer stack for a two-terminal selector device. The layer stack comprises: a first layer of a semiconductor with a first band-gap arranged in contact with a first electrode; a third layer of a semiconductor with a third band-gap arranged in contact with a second electrode; and a second layer of a threshold switching material with a second band-gap being larger than the first and third band-gap, the second layer being arranged between the first layer and the third layer

By the term "threshold switching material" is meant a material that exhibits an electronic threshold mechanism at a specific threshold voltage (Vth) (sometimes referred to as a corresponding threshold current density (Jth)). The material exhibits a high resistance to current in response to voltages below Vth (a "non-conducting" or "off" state) and a low resistance to current in response to voltages above Vth (a "conducting" or "on" state).

The second layer may be in direct contact (i.e. in abutment) with the first and third layer. It is however envisaged that one or more interfacial layers, e.g. relatively thin layers that do not impact the band engineered properties of the layer stack, may be present between the second layer and the first layer, and/or between the second layer and the third layer. Such an interfacial layer may e.g. be a 2-5 nm thick or an even thinner layer of for example a semiconductor different from the one(s) of the first or third layer.

In an example band engineered operation, by the second band-gap being larger than the first and third band-gap, the tunneling distance is effectively shortened at a sufficiently high voltage bias (i.e. sufficiently high negative or high positive applied voltage). This is because at a voltage bias corresponding to a charge carrier energy greater than the first and third band-gap but lower than the second band-gap, the voltage drop along the layer stack causes the injected charge carrier to effectively "sense" only the higher, second layer, as a barrier. The consequence of this is that current density is boosted, for example when a current is applied with a voltage at a high-field "read" regime, compared to an applied voltage lower than this value. At low voltage bias (corresponding to an off state or to unselected cells in a memory array), instead, the charge carriers encounter a tunnelling distance resulting from the bandgap of all three layers, resulting in a much lower current and thereby a boost of selectivity (on/off ratio).

When using a threshold switching material as second layer, the device further experiences a second "current-boost" when the current density increases over a certain threshold Jth causing the layer to enter to a "dynamic-on" state of very low resistivity.

However, the current is still tunnel-limited by the first and third layers at voltages higher than Vth, thereby limiting any potential voltage snapbacks. Accordingly, a high NL is achieved while mitigating the drawback of voltage snapbacks.

By selecting specific materials and thicknesses of the layer stack, the current density threshold may be engineered to be below the required "write" current density but above the "read" current density. This may further enhance reliability of the selector by limiting the above-threshold transition to only be during the write operation.

Thus, a further benefit of this layer stack is that at current densities below Jth, the layer stack acts as a conventional metal-semiconductor-metal (MSM) cell. For example, in a memory cell comprising a two-terminal selector device comprising the layer stack, the MSM characteristics may be used for read operations of a resistive memory element comprised in the memory cell as such an operation may not require a high Jon.

According to one embodiment, the first and third layers are made from the same material and have the same thickness.

This simplifies manufacturing and ensures that the same J-V characteristics exist for opposite voltage signs. Memory cells of MRAMs may be bipolar, in the sense that they exhibits the same behavior for both positive and negative voltages, and may accordingly be read or written to by a current of either polarity, The symmetry in the layer structure and hence also symmetry in the J-V characteristics may thereby be beneficial for use in a bipolar selector in such an MRAM comprising bipolar memory cells.

According to one embodiment, the first and third layers are made from an amorphous semiconductor material.

This enables a relatively stable and predictable bandgap without impurities that may otherwise increase leakage currents in an off-state of the semiconductor device.

According to one embodiment, the second layer is an ovonic threshold switching material.

This combines the well-established properties of OTS materials with the inventive band engineering of the layer stack.

According to one embodiment, the second band-gap is at least 1.3 eV.

This facilitates a relatively low Vth while also limiting leakage currents and not unduly limiting the choice of semiconductor(s) for the first and third layers.

According to one embodiment, the first and third band-gaps are smaller than 1.3 eV.

This ensures that read operations may be performed with a relatively low applied voltage.

According to a second aspect of the present inventive concept, a two-terminal selector device comprising the layer stack according to the first aspect is provided.

By the term "two-terminal selector device" is meant a device exhibiting a high resistance to current in response to voltages below a threshold (a "non-conducting" or "off" state) and a low resistance to current in response to voltages above the threshold (a "conducting" or "on" state).

The selector may be bipolar in the sense that it exhibits this behavior for both positive and negative voltages, and may accordingly block or allow a current of either polarity.

This aspect may generally present the same or corresponding advantages as the former aspect.

According to a third aspect of the present inventive concept, a method for controlling a memory cell comprising a resistive memory element and the two-terminal selector device according to the second aspect for use in an MRAM structure is provided. The control method comprises a read method comprising the steps of: applying a read voltage lower than a threshold voltage (Vth) to the memory cell; and sensing a resistance state of the resistive memory element of the memory cell. The control method further comprises a write method comprising the steps of: applying a write voltage higher than Vth to the memory cell; and setting a resistance state of the resistive memory element of the memory cell.

By the term "resistive memory element" is meant a non-volatile resistive element configured to be switchable between a first/low resistance state and a second/high resistance state in response to a switching/setting/writing current. Such a current-programmable device is sometimes also referred to as a "memristor."

By the term "resistance state" is meant one of at least two states of the resistive memory element in which each state has a distinct resistance. This may e.g. correspond to a parallel and anti-parallel spin state of a layer (e.g. a storage layer or free layer) of the resistive memory.

By the term "threshold voltage" is meant, in the context of a memory cell, a voltage value corresponding to the threshold voltage of the two-terminal selector device of the memory cell plus any expected voltage loss e.g. due to a resistance of the resistive memory element, such that the threshold voltage of the memory cell corresponds to a voltage drop over the two-terminal selector device being the threshold voltage of the two-terminal selector device. It is noted that an expected voltage loss e.g. due to a resistance of the resistive memory element may be much smaller than the threshold voltage of the two-terminal selector device.

Such a memory cell is well-suited for use in an MRAM device.

By the read voltage being lower than Vth, the endurance lifetime of the memory cell is greatly increased. This is because of a reduction of the number of operations using more degrading Jon that are induced when Vth is exceeded.

By the write voltage being higher than Vth, a sufficiently high Jon is achieved to ensure switching of said at least one memory element.

Thus, a balance is struck between consistent performance of the memory cell and its lifetime endurance.

According to one embodiment, Vth is between 1 V and 1.5 V.

This ensures a relatively low read voltage and reduces the overall energy consumption of the memory cell.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is a schematic view of a two-terminal selector device according to an embodiment.
Fig. 2 is a schematic view of a layer stack according to an embodiment.
Fig. 3 shows J-V characteristics of the prior art.
Fig. 4 shows J-V characteristics of the layer stack according to different embodiments.
Fig. 5 shows a memory cell according to an embodiment.
Fig. 6 shows an MRAM comprising memory cells according to an embodiment.
Fig. 7 shows read- and write methods of a memory cell according to an embodiment.

### Detailed description

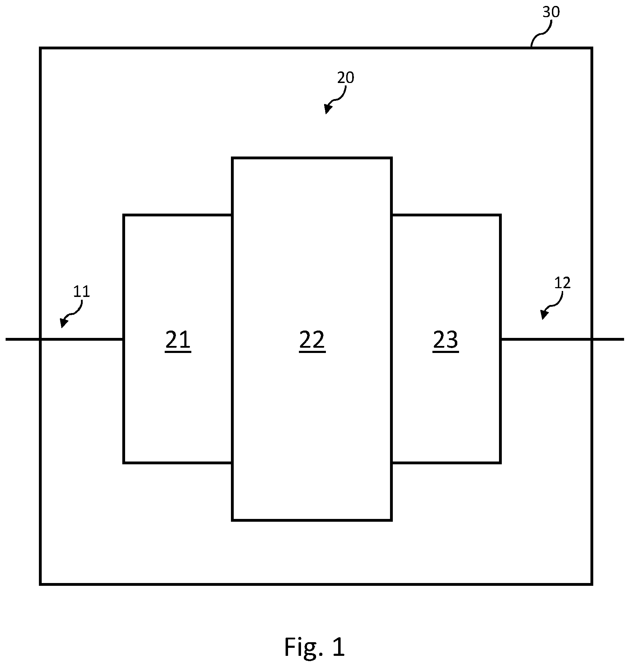

Fig. 1 illustrates a two-terminal selector device 30 comprising a layer stack 20 arranged between two electrodes 11, 12. The layer stack 20 comprises a first 21, second 22 and third 23 layer.

Fig. 1 illustrates an energy band-gap of the layer stack 20 and the electrodes 11, 12, whereby the second layer 22 has a second band-gap being larger than the first and third band-gap of the first and third layers 21,23 and the electrodes 11, 12 do not have a band-gap. In Fig. 1, no voltage is applied across the layer stack 20.

In the shown example, the first and third band-gap is 0.9 eV and the second band-gap is 1.5 eV. Other values are possible, such as the first and third band-gap being 0.5-1.3 eV and the second band-gap being 1.3-2 eV.

The first and third layer 21, 23 are shown in Fig. 1 as having the same thickness, which is different from the second layer 22. In alternative embodiments each layer may have a different or same thickness between 1-15 nm, such as 4 nm or 8 nm.

The first and third layer 21, 23 may be made from an amorphous semiconductor material such as amorphous silicon or germanium and may be bilayers in some embodiments. The second layer 22 is made from a threshold switching material, for example an ovonic threshold switching material such as GeSe, GeS, GeAsSe, GeAsS, GeSbSe, and GeSbS families.

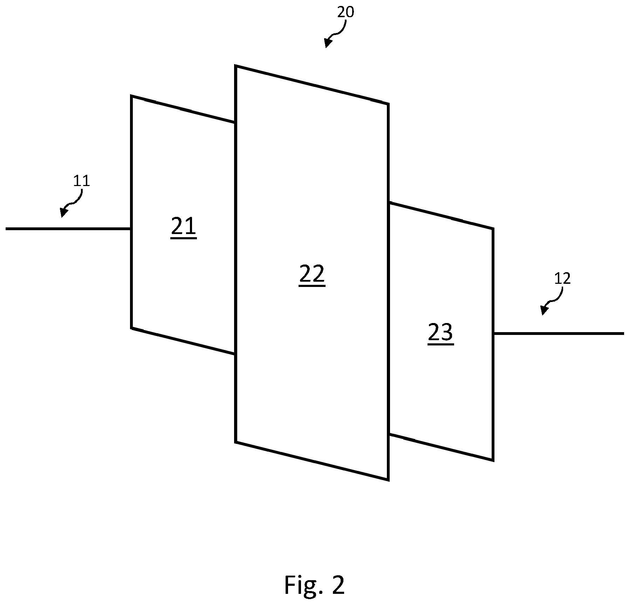

Fig. 2 illustrates a layer stack 20 arranged between two electrodes 11, 12, similar to the structure of Fig. 1. Fig. 2 illustrates an energy band-gap of the layer stack 20 and the electrodes 11, 12 similar to Fig. 1, however in Fig. 2 a voltage is applied across the layer stack 20.

The applied voltage causes a slant across the band-gaps that enables charge carriers to tunnel across a tip of the first or third layer 21, 23, depending on whether the charge carrier is an electron or a hole. This because of the reduced thickness of the tip compared to the rest state, i.e. when no voltage is applied.

With a single semiconductor layer, as more voltage is applied, the tips get relatively thinner causing the current across the layer to increase linearly as a function of the applied voltage.

With three layers and with a second band-gap is larger than the first and third band-gap, the charge carriers will accumulate at the interface between the second layer 22 and the first and third layers 21, 23.

If the second layer 22 would have been a conventional amorphous semiconductor like the first and third layers 21, 23, the larger band-gap would cause the current to exhibit some non-linearity as a function of the applied voltage as the accumulated charge carriers eventually start tunneling across the second layer 22 at a specific applied voltage.

According to the present inventive concept, the second layer 22 is a threshold switching material rather than a conventional amorphous semiconductor. This means that when a voltage of at least a threshold voltage Vth is applied across the threshold switching material, the resistance of the threshold switching material suddenly drops and the current across the threshold switching material is greatly and non-linearly increased. Fig. 2 shows an applied voltage below Vth.

This increase is a result of material properties of the threshold switching material, which causes the applied voltage above this point to redistribute to other parts of the device, which is called voltage snapback. In the present embodiment, this voltage drop occurs over the first and third layers 21, 23. This voltage drop may cause a slight increase in the tunneling current across the first and third layers 21, 23, however Vth is usually high enough, depending on material choice and thickness, that this change is negligible.

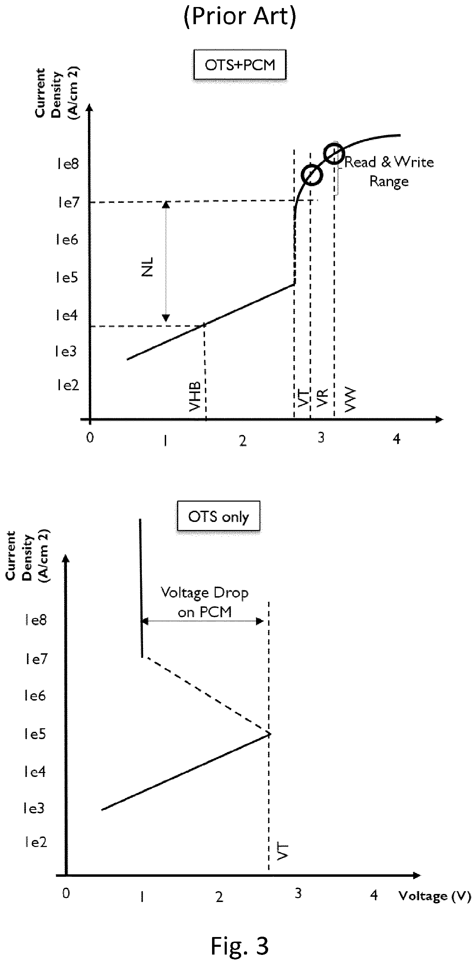

Fig. 3 shows these characteristics of only using a threshold switching material according to the prior art through the use of J-V plots. The J-V plots show the current density of a selector device with a threshold switching material implemented in a PCM (top plot) and only the selector device (bottom plot) as a function of the applied voltage.

In these plots, Vth is around 2.7 V and shown as VT. When Vth is applied across the device the current density is sharply increased as a result of the resistance drop of the threshold switching material.

The "threshold" concept may be understood as threshold switching occurring when applying a current density above a threshold current density Jth through the device. This concept may be more practical when considering selector and memory element stacking than considering a threshold voltage Vth.

The top plot shows an example read voltage VR and write voltage VW as well as VHB, being half of the applied voltage (VR in read condition, VW in write case). The top plot further shows a measurement of the non-linearity of the J-V plot, taken as the difference in current density between Vth and VHB.

The bottom plot shows what happens to the threshold switching material when this threshold switch occurs. Once the applied voltage reaches Vth, the voltage applied to the threshold switching material is redistributed to the PCM, causing a voltage snapback.

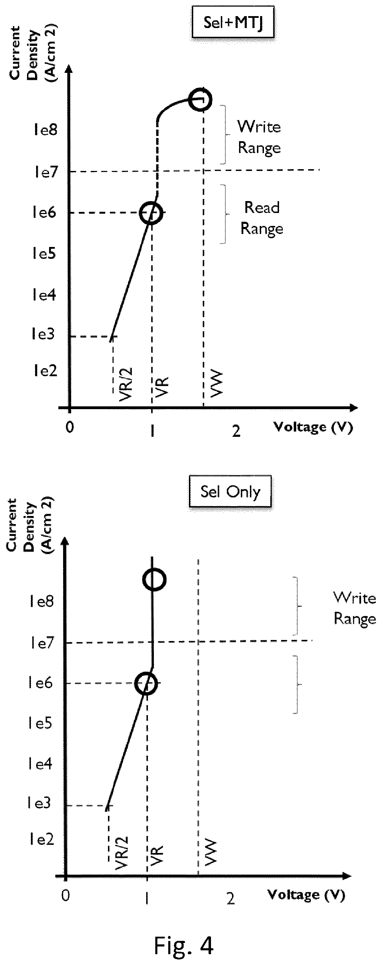

Fig. 4 shows J-V plots for a selector device comparable to the device used for the plots in Fig. 3 but instead of only a switching material the selector device comprises a layer stack according to the inventive concept as previously described in relation to Figs. 1-2. Similar to Fig. 3, the top plot shows the current density of the selector device implemented in a memory cell and the bottom plot shows the current density of only the selector device, both as a function of the applied voltage.

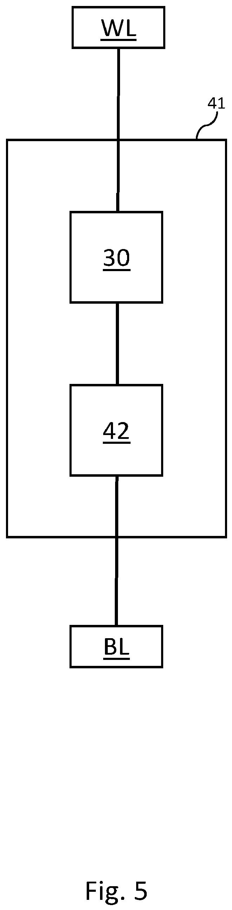

In these plots, Vth is around 1.1 V as is apparent from the sharp increase in current density at that voltage. As will be explained further in relation to Fig. 5, the J-V characteristics of the layer stack allows the values for VR and VW to be separated further, with VR being below Vth and VW being above Vth. The measured non-linearity value is similar to the value shown in Fig. 3.

It is noted that Vth may vary slightly between the top plot and the bottom plot as the top plot also considers the voltage loss over a resistive memory element of the memory cell as part of Vth. However, this loss is much smaller than Vth of the selector device as shown in the bottom plot, so the difference is not distinguishable from the plots.

The bottom plot no longer shows a voltage drop after Vth compared to in Fig. 3 because this voltage drop is absorbed by the first and third layer of the layer stack, surrounding the threshold switching material. Accordingly, any effect to the selector device comprising the layer stack by the voltage drop is mitigated and therefore no relevant voltage snapback occurs.

Fig. 5 shows a memory cell 41 comprising a resistive memory element 42 and a two-terminal selector device 30 as described in relation to Fig. 1. The two-terminal selector device 30 comprises the layer stack according to the present inventive concept.

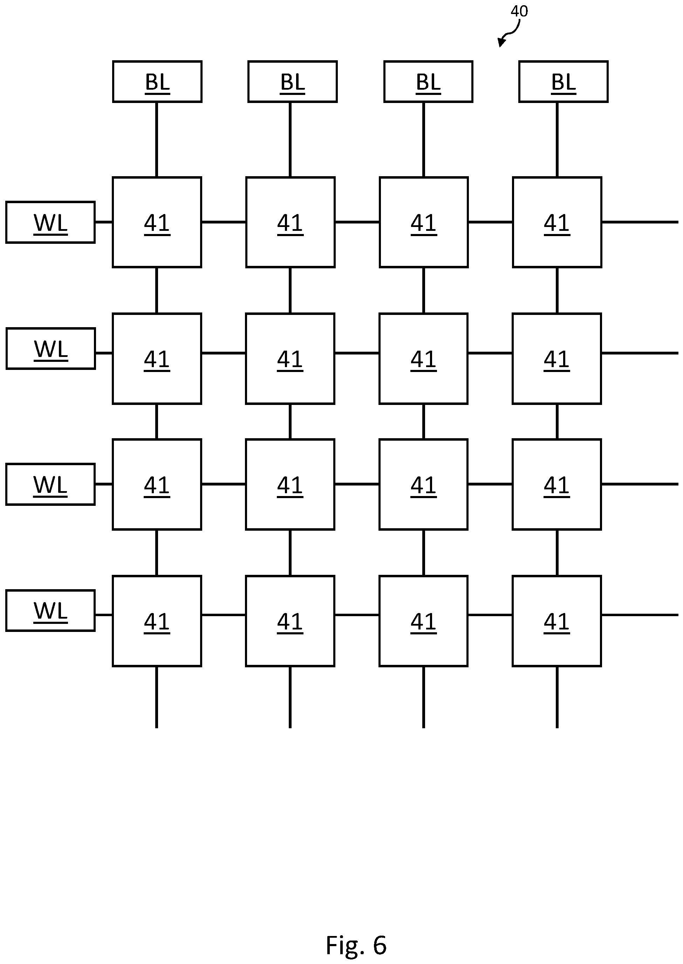

The memory cell 41 is part of a larger resistive memory device such as a Magnetic Random Access Memory (MRAM) or resistive RAM (ReRAM). The memory cell 41 is addressed using a word-line (marked as WL) and a bit-line (marked as BL). More details regarding the memory device will be discussed in relation to Fig. 6.

The resistive memory element 42 may be switched between a higher resistance and a lower resistance state by applying appropriate write currents/voltages via the bit-line and word-line. The state of a resistive memory element 42 may be read by applying a read voltage to the resistive memory element 42 and sensing the state e.g. using a sense amplifier. The resistive memory element 42 may be realized e.g. using a magnetic tunneling junction device.

The memory cell 41 is supplemented by a two-terminal selector 30 connected in series with the resistive memory element 42 between BL and WL. The two-terminal selector 30 may be bipolar. The two-terminal selector 30 may block current (i.e. present a high resistance to current) for voltages below a predetermined value and allow current (i.e. present a low resistance to current) for voltages above the predetermined value. The two-terminal selector 30 thus enables the memory cell 41 to have a reduced leakage currents as well as a more selective read and write access.

By the two-terminal selector 30 comprising a layer stack that exhibits the J-V characteristics as previously discussed in relation to Fig. 4, the current density through the two-terminal selector 30 is relatively high when applying a read or write voltage similar to the one shown in Fig. 4. Comparing these current densities to the current density for half the read voltage, which can be considered a maximum for an applied voltage when the memory cell 41 is intended to be in the off state, the resistive memory element 42 may be highly selective to only change, i.e. be written to, when intended.

Beyond the advantage that no voltage snapback occurs, the proposed memory cell 41 also achieves a relatively high current density with a relatively low applied voltage. Comparing Figs. 3 and 4, the write voltage is roughly half using the layer stack according to the present inventive concept compared to the write voltage used in the prior art structure of Fig. 3 to achieve the same current density. This lowers energy consumption of the memory cell 41.

Another advantage of the layer stack according to the present inventive concept when implemented in a memory cell 41 is that the read voltage may be below Vth and the write voltage may be above Vth. This is because the non-linearity value of the J-V characteristics of the layer structure as shown in Fig. 4 is sufficiently high also in the region before Vth. In this region, the tunneling current over the first and third layers of the layer stack is the main physical effect causing a linear but steep increase of the current density as a function of applied voltage.

The write voltage may be above Vth in order to achieve a sufficiently high current density for a writing operation, but this separation of the read and write voltage means that the resistive memory element 42 may be highly selective also to differentiate between these operations.

Fig. 6 shows a resistive memory device 40, such as an MRAM, comprising memory cells 41 as described in relation to Fig. 5.

The resistive memory device 40 is a cross-point memory device. In a cross-point memory device, bit-lines and word-lines may be arranged in different metal layers/metallization levels, with the memory cells 41 located at the crossings between the bit-lines and word-lines. This design enables relatively high-density memory arrays.

In order to address a specific memory cell 41, a read- or write voltage is applied to the bit-line and word-line that intersects that memory cell 41. As each memory cell 41 comprises a two-terminal selector device as described in relation to Fig. 5, only the specific memory cell 41 that intersects both the bit-line and word-line receives a sufficiently high current density through the resistive memory element to allow the operation.

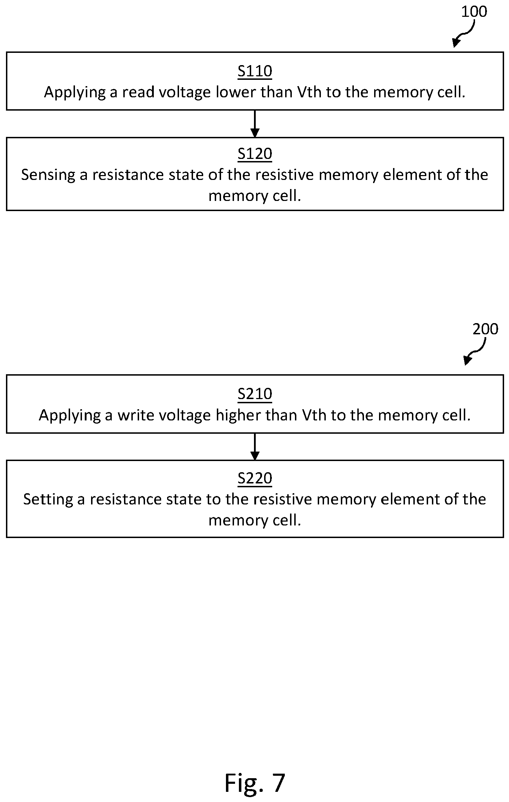

Fig. 7 shows two flowcharts for a read method 100 and a write method 200, respectively, of a memory cell as described in relation to Fig. 5. These two methods 100, 200 together form a control method of the memory cell.

The read method 100 comprises a first step of applying S110 a read voltage lower than Vth to the memory cell. Vth is the threshold voltage of the threshold switching material of the second layer of the layer stack in the two-terminal selector device of the memory cell being controlled. Vth may be between 1-1.5 V.

The read method 100 further comprises a second step of sensing S120 a resistance state of the resistive memory element of the memory cell, e.g. using a sense amplifier.

The write method 200 comprises a first step of applying S210 a write voltage higher than Vth to the memory cell.

The write method 200 further comprises a second step of setting S220 a resistance state to the resistive memory element of the memory cell.

By the read method 100 operating below Vth, the J-V characteristics of the layer stack is static when reading from the resistive memory element of the memory cell.

By the write method 200 operating above Vth, the J-V characteristics of the layer stack is dynamic when writing to the resistive memory element of the memory cell.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A layer stack (20) for a two-terminal selector device, the layer stack comprising:
a first layer (21) of a semiconductor with a first band-gap arranged in contact with a first electrode (11);
a third layer (23) of a semiconductor with a third band-gap arranged in contact with a second electrode (13); and
a second layer (22) of a threshold switching material with a second band-gap being larger than the first and third band-gap, the second layer being arranged between the first layer (21) and the third layer (23).

2. The layer stack according to claim 1, wherein the first and third layers (21, 23) are made from the same material and have the same thickness.

3. The layer stack according to claim 1 or 2, wherein the first and third layers (21, 23) are made from an amorphous semiconductor material.

4. The layer stack according to any one of the previous claims, wherein the second layer (22) is an ovonic threshold switching material.

5. The layer stack according to any one of the previous claims, wherein the second band-gap is at least 1.3 eV.

6. The layer stack according to any one of the previous claims, wherein the first and third band-gaps are smaller than 1.3 eV.

7. A two-terminal selector device (30) comprising the layer stack (20) according to any one of the preceding claims.

8. A method for controlling a memory cell (41) comprising a resistive memory element (42) and the two-terminal selector device (30) according to claim 7, the control method comprising a read method (100) comprising steps of:
applying (S110) a read voltage lower than a threshold voltage, Vth, to the memory cell (41); and
sensing (S120) a resistance state of the resistive memory element (42) of the memory cell (41);
the control method further comprising a write method (200) comprising steps of:
applying (S210) a write voltage higher than Vth to the memory cell (41); and
setting (S220) a resistance state to the resistive memory element (42) of the memory cell (41).

9. The memory cell according to claim 8, wherein Vth is between 1 V and 1.5 V.
